# EUROPEAN PATENT APPLICATION

(11) **EP 4 665 099 A1**
(43) Date of publication of application: **17.12.2025**
(21) Application number: 24870110.4
(22) Date of filing: 06.08.2024
(51) Int. Cl.: H05K 7/20, H04M 1/02

(54) **ELECTRONIC DEVICE**

(30) Priority: 25.09.2023 CN 202322610728 U
(71) Applicant: Honor Device Co., Ltd., Shenzhen, Guangdong 518040 (CN)
(72) Inventor: LU, Tao, Shenzhen, Guangdong 518040 (CN); ZHU, Ailan, Shenzhen, Guangdong 518040 (CN); YANG, Fan, Shenzhen, Guangdong 518040 (CN)
(74) Representative: Gill Jennings & Every LLP
(86) International application number: PCT/CN2024/110150
(87) International publication number: WO 2025/066561

(57) **Abstract**

This application provides an electronic device, and the electronic device includes: a display screen; a rear cover; a middle frame, located between the display screen and the rear cover, where the display screen and the rear cover are mounted on the middle frame; a main board, mounted on the middle frame, and located between the display screen and the rear cover; a first chip module, welded on a first surface of the main board by using a solder ball; and a first shielding case, located on the first surface of the main board, and shielding the first chip module, where a heat conduction layer is formed between the first chip module and the first shielding case, and between the first shielding case and the display screen; and a thermal conductive underfill that wraps the solder ball is filled between the first chip module and the main board, and thermal conductivity of the thermal conductive underfill is greater than or equal to 0.5 w/m·K. In this application, a heat dissipation path of a chip may be added, which helps dissipate heat of the chip as quickly as possible, thereby improving a heat dissipation capability of the chip, facilitating performance release for the chip, and enhancing user experience.

## Description

This application claims priority to Chinese Patent Application No. 202322610728.3, filed with the China National Intellectual Property Administration on September 25, 2023 and entitled "ELECTRONIC DEVICE", which is incorporated herein by reference in its entirety.

### TECHNICAL FIELD

This application relates to the field of electronic device technologies, and in particular, to an electronic device.

### BACKGROUND

With continuous development of technologies, performance of an electronic device such as a mobile phone is increasingly strong, and power consumption of the device is also continuously increased. Chips such as a system on chip (SOC), a double-rate synchronous dynamic random storage chip (DDR), a power management chip (PMU), and a charging chip (charger) generate heat more seriously during use, and a heat dissipation requirement of the device is increasingly high. At present, a main heat dissipation manner of the electronic device such as the mobile phone is to export heat of a chip to a screen side or a rear housing side of the mobile phone by using a thermal conductive gel or a thermal conductive pad. For example, the thermal conductive gel or the thermal conductive pad is disposed between a top of the chip and a shielding frame/screen membrane, between the shielding frame/screen membrane and a middle frame/vapor chamber (Vapor Chamber, VC for short), so that the heat of the chip such as the SOC or the DDR is exported along the screen side, and the heat of the chip such as the PMU or the Charger is exported along the rear housing side, thereby implementing heat dissipation of the chip. However, at present, this heat dissipation manner gradually fails to meet the continuously increased heat dissipation requirement of the device, and consequently the chip generates heat seriously, thereby suppressing full release of chip performance, causing heating or lagging of the mobile phone, and affecting user experience.

### SUMMARY

To resolve the foregoing technical problems, this application provides an electronic device. In the electronic device, a heat dissipation path of a chip may be added, which helps dissipate heat of the chip as quickly as possible, thereby improving a heat dissipation capability of the chip, facilitating performance release for the chip, and enhancing user experience.

According to a first aspect, this application provides an electronic device, including:
a display screen;
a rear cover;
a middle frame, where the middle frame is located between the display screen and the rear cover, and the display screen and the rear cover are mounted on the middle frame;
a main board, where the main board is mounted on the middle frame and located between the display screen and the rear cover, and the main board includes a first surface facing the display screen and a second surface facing the rear cover;
a first chip module, where the first chip module is welded on the first surface of the main board by using a solder ball; and
a first shielding case, where the first shielding case is located on the first surface of the main board, and shields the first chip module, where
a heat conduction layer is formed between the first chip module and the first shielding case, and between the first shielding case and the display screen; and
a thermal conductive underfill that wraps the solder ball is filled between the first chip module and the main board, and thermal conductivity of the thermal conductive underfill is greater than or equal to 0.5 w/m·K.

According to the first aspect, in this application, the thermal conductive underfill with high thermal conductivity is filled between the first chip module and the main board, so that heat generated by the first chip module, on the one hand, can be conducted to a display screen side through a shielding case for heat dissipation, and on the other hand, can be conducted to the main board through the thermal conductive underfill, and heat dissipation is performed by using the main board. In this way, the heat generated by the first chip module may be dissipated from a plurality of heat dissipation paths, thereby improving a heat dissipation capability of the chip, facilitating performance release for the chip, and enhancing user experience.

According to the first aspect or any one of the foregoing implementations of the first aspect, the electronic device further includes:
a second chip module, where the second chip module is welded on the second surface of the main board by using a solder ball; and
a second shielding case, where the second shielding case is located on the second surface of the main board, and shields the second chip module, where
a heat conduction layer is formed between the second chip module and the second shielding case, and between the second shielding case and the rear cover; and
the thermal conductive underfill that wraps the solder ball is filled between the second chip module and the main board.

In such an arrangement, the thermal conductive underfill with high thermal conductivity is filled between the second chip module and the main board, so that heat generated by the second chip module, on the one hand, can be conducted to a rear cover side through the shielding case for heat dissipation, and on the other hand, can be conducted to the main board through the thermal conductive underfill, and heat dissipation is performed by using the main board. In this way, the heat of the second chip module may be dissipated from a plurality of heat dissipation paths, thereby improving a heat dissipation capability of the chip, facilitating performance release for the chip, and enhancing user experience.

According to the first aspect or any one of the foregoing implementations of the first aspect, the electronic device further includes:
a heat dissipation hole, where the heat dissipation hole is located in an area, on the main board, in which the first chip module is located, and runs through the main board, and the heat dissipation hole is filled with the thermal conductive underfill;
a first thermal sheet, where the first thermal sheet is located at a position that is on the second surface of the main board and that corresponds to the first chip module; and
a third shielding case, where the third shielding case is located at a position that is on the second surface of the main board and that corresponds to the first chip module, and shields the first thermal sheet, where
a heat conduction layer is formed between the first thermal sheet and the third shielding case, and between the third shielding case and the rear cover.

In such an arrangement, heat generated by the first chip module may be further conducted to the other side of the main board through the heat dissipation hole, and conducted to the rear cover side through the thermal sheet, the heat conduction layer, and the shielding case for heat dissipation. In this way, a heat dissipation path is added, so that the heat of the first chip module can be dissipated from a plurality of heat dissipation paths, thereby improving a heat dissipation capability of the chip, facilitating performance release for the chip, and enhancing user experience.

According to the first aspect or any one of the foregoing implementations of the first aspect, the electronic device further includes:
a heat dissipation hole, where the heat dissipation hole is located in an area, on the main board, in which the second chip module is located, and runs through the main board, and the heat dissipation hole is filled with the thermal conductive underfill;
a second thermal sheet, where the second thermal sheet is located at a position that is on the first surface of the main board and that corresponds to the second chip module; and
a fourth shielding case, where the fourth shielding case is located at a position that is on the first surface of the main board and that corresponds to the second chip module, and shields the second thermal sheet, where
a heat conduction layer is formed between the second thermal sheet and the fourth shielding case, and between the fourth shielding case and the display screen.

In such an arrangement, heat generated by the second chip module may be further conducted to the other side of the main board through the heat dissipation hole, and conducted to the display screen side through the thermal sheet, the heat conduction layer, and the shielding case for heat dissipation. In this way, a heat dissipation path is added, so that the heat of the second chip module can be dissipated from a plurality of heat dissipation paths, thereby improving a heat dissipation capability of the chip, facilitating performance release for the chip, and enhancing user experience.

According to the first aspect or any one of the foregoing implementations of the first aspect, a distance between the heat dissipation hole and the solder ball is greater than or equal to 30 um. In such an arrangement, impact on the solder ball may be avoided.

According to the first aspect or any one of the foregoing implementations of the first aspect, a diameter of the heat dissipation hole is 60-90 um. Such an arrangement can ensure a sufficient heat dissipation capability, so that heat generated by the chip can be rapidly conducted to the other side of the main board for heat dissipation.

According to the first aspect or any one of the foregoing implementations of the first aspect, a heat dissipation channel is formed between the first chip module and/or the second chip module and the middle frame, and the heat dissipation channel is filled with the thermal conductive underfill. In such an arrangement, heat generated by the chip may be conducted to the middle frame through the heat dissipation channel for heat dissipation. In this way, a heat dissipation path is added, so that the heat of the chip can be dissipated from a plurality of heat dissipation paths, thereby improving a heat dissipation capability of the chip, facilitating performance release for the chip, and enhancing user experience.

According to the first aspect or any one of the foregoing implementations of the first aspect, a welded metal member is disposed, on the middle frame, adjacent to the first chip module or the second chip module, a heat dissipation channel is formed between the welded metal member and the first chip module or the second chip module, and the heat dissipation channel is filled with the thermal conductive underfill. In such an arrangement, heat generated by the chip may be conducted to the welded metal member/middle frame through the heat dissipation channel for heat dissipation. In this way, a heat dissipation path is added, so that the heat of the chip can be dissipated from a plurality of heat dissipation paths, thereby improving a heat dissipation capability of the chip, facilitating performance release for the chip, and enhancing user experience.

According to the first aspect or any one of the foregoing implementations in the first aspect, the heat conduction layer includes a thermal conductive gel or a thermal conductive pad. This can ensure that heat generated by the chip is rapidly conducted to the outside.

According to the first aspect or any one of the foregoing implementations of the first aspect, the first chip module includes at least one chip, the second chip module includes at least one chip, and the thermal conductive underfill wraps a solder ball of each of the chips. This can ensure that heat generated by the chip is rapidly conducted to the outside.

### BRIEF DESCRIPTION OF DRAWINGS

FIG. 1 is an example schematic diagram of a structure of an electronic device;
FIG. 2 is an example schematic diagram of a heat dissipation structure of an electronic device;
FIG. 3 is a schematic cross-sectional view of an electronic device according to an embodiment of this application;
FIG. 4 is a partially enlarged view of a dotted line region in FIG. 3;
FIG. 5 is a schematic cross-sectional view of an electronic device according to another embodiment of this application;
FIG. 6 is a partially enlarged view of a dotted line region in FIG. 5;
FIG. 7 is a schematic cross-sectional view of an electronic device according to still another embodiment of this application; and
FIG. 8 is a partially enlarged view of a dotted line region in FIG. 7.

### DESCRIPTION OF EMBODIMENTS

The following clearly and completely describes the technical solutions in the embodiments of this application with reference to the accompanying drawings in the embodiments of this application. Clearly, the described embodiments are some rather than all of the embodiments of this application. All other embodiments obtained by persons of ordinary skill in the art based on the embodiments of this application without creative efforts shall fall within the protection scope of this application.

In the specification, the term "and/or" is merely used to describe an association relationship between associated objects, and indicates that three relationships may exist. For example, A and/or B may indicate the following three cases: Only A exists, both A and B exist, and only B exists.

The terms "first", "second", and the like in the specification and claims of the embodiments of this application are used to distinguish between different objects, and are not used to describe a particular order of the objects. For example, a first target object, a second target object, and the like are used to distinguish between different target objects, and are not used to describe a particular order of the target objects.

In the embodiments of this application, words such as "example" or "for example" are used to indicate an example, illustration, or description. Any embodiment or design solution described as "an example" or "for example" in the embodiments of this application should not be explained as being more preferred or having more advantages than other embodiments or design solutions. Exactly, the words such as "example" or "for example" are intended to present related concepts in a specific manner.

In the descriptions of the embodiments of this application, unless otherwise stated, "a plurality of" means two or more. For example, "a plurality of processing units" indicates two or more processing units, and "a plurality of systems" indicates two or more systems.

UNDERFILL: bottom filling adhesive, bottom filling adhesive, underfill, bottom filling agent, bottom filling agent, bottom filler, bottom filling adhesive, or the like, which is an adhesive used to protect solder balls of some welded chips in an electronic product, and is used for a CSP or BGA bottom filling process. The underfill can form a consistent and defect-free bottom filling layer, and can effectively reduce impact caused by an external force, or a mismatch of an overall thermal expansion characteristic between a silicon chip and a substrate. The underfill can be quickly cured when being heated. A characteristic of a lower viscosity enables the underfill to be better used for bottom filling, and higher fluidity strengthens operability of repair of the underfill.

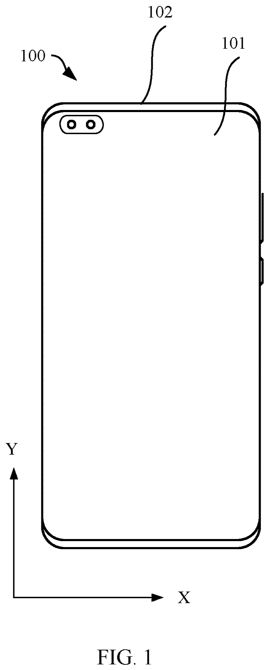

An embodiment of this application provides a terminal device. The terminal device may be an electronic device having a camera module, such as a mobile phone, a tablet computer, a personal digital assistant (personal digital assistant, PDA), or an in-vehicle computer. A specific form of the foregoing electronic device is not limited in this embodiment of this application. As shown in FIG. 1, for ease of description, an example in which the terminal device is a mobile phone is used below for description.

To clearly describe subsequent structural features and a positional relationship of the structural features, a positional relationship of each structure in the mobile phone is specified by using an X-axis direction, a Y-axis direction, and a Z-axis direction. As shown in FIG. 1, the X-axis direction is a width direction of the mobile phone, the Y-axis direction is a length direction of the mobile phone, and the Z-axis direction is a thickness direction of the mobile phone.

As shown in FIG. 1, a mobile phone 100 includes a housing 101 and a display screen 102 mounted on the housing 101. The housing 101 includes a middle frame (not shown) and a rear cover. A main board of the mobile phone is mounted on the middle frame. Various chips and electronic components are mounted on the main board, and are wrapped by the display screen 102 and the rear cover. As described above, at present, a main heat dissipation manner of the electronic device such as the mobile phone is to export heat of a chip to a screen side or a rear housing side of the mobile phone by using a thermal conductive gel or a thermal conductive pad. For example, the thermal conductive gel or the thermal conductive pad is disposed between a top of the chip and a shielding frame/screen membrane, and between the shielding frame/shielding membrane and the middle frame/a vapor chamber (Vapor Chamber, VC for short), so that heat of the chip such as an SOC or a DDR is exported along the screen side, and heat of the chip such as a PMU or a Charger is exported along the rear housing side, thereby implementing heat dissipation of the chip.

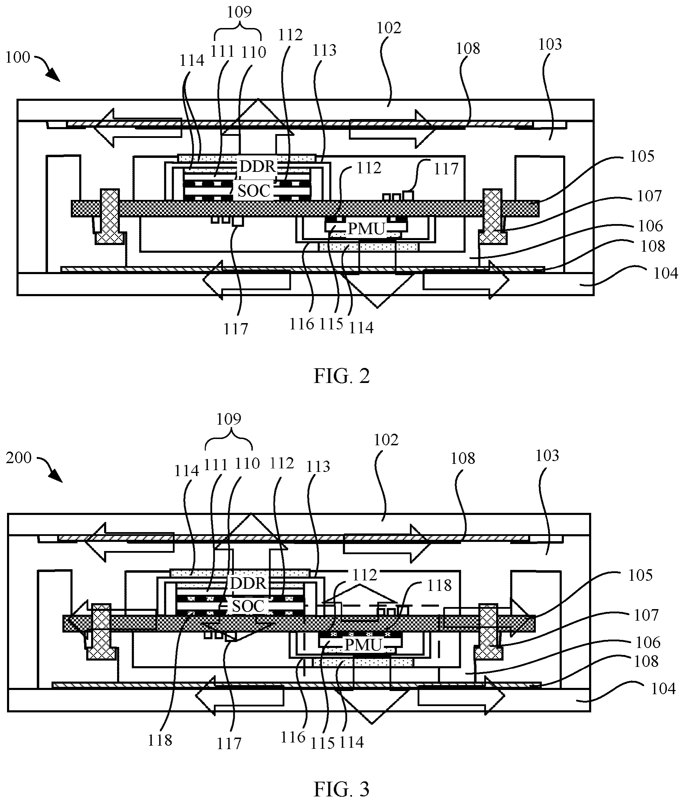

FIG. 2 is an example schematic diagram of a heat dissipation structure of an electronic device. As shown in FIG. 2, an electronic device 100 includes the display screen 102, a middle frame 103, and a rear cover 104, where the middle frame 103 and the rear cover 104 constitute the housing 101 in FIG. 1. The display screen 102 and the rear cover 104 are mounted on the middle frame 103. The display screen 102, the middle frame 103, and the rear cover 104 jointly form an accommodating cavity, and various components required by the device are mounted in the accommodating cavity, such as a processor (SOC), a battery, and a camera module. As shown in FIG. 2, a main board 105 and a main board bracket 106 are mounted on the middle frame 103, the main board 105 is sandwiched between the middle frame 103 and the main board bracket 106, and the main board bracket 106 is fixed on the middle frame 103 by using a fastener 107 such as a screw. In the example shown in FIG. 2, a graphite layer 108 is disposed in a gap between the display screen 102 and the middle frame 103, and a gap between the main board bracket 106 and the rear cover 104. Heat generated by an electronic component on the main board 105 may be dissipated to the outside with the help of the display screen 102 and the rear cover 104 by using the graphite layer 108.

As shown in FIG. 2, the main board 105 includes a first surface and a second surface that are opposite to each other, the first surface is a surface of a side facing the display screen 102, and the second surface is a surface of a side facing the rear cover 104. For example, a first chip module 109 is fixed on the first surface of the main board 105. For example, the first chip module 109 includes a first chip 110 such as an SOC chip and a second chip 111 such as a DDR chip. The first chip 110 is welded on the first surface of the main board 105 by using a solder ball 112. The second chip 111 is welded on the first chip 110 by using a solder ball 112. A first shielding case 113 is further mounted on the first surface of the main board 105, and is configured to shield the first chip module 109 to prevent radiation to the outside and being radiated, that is, reduce electromagnetic radiation and prevent signal interference. As shown in FIG. 2, a heat conduction layer 114 is disposed in a gap between the second chip 111 and the first shielding case 113, and a gap between the first shielding case 113 and the middle frame 105. The heat conduction layer 114 is, for example, a thermal conductive gel or a thermal conductive pad, and the heat conduction layer 114 may be formed in the foregoing gaps in a manner of coating, bonding, or the like.

For example, a second chip module 115 is fixed on the second surface of the main board 105. The second chip module 115 includes a third chip, and the third chip is, for example, a PMU chip. The second chip module 115 is welded on the second surface of the main board 105 by using the solder ball 112. A second shielding case 116 is further mounted on the second surface of the main board 105, and is configured to shield the second chip module 115, to prevent radiation to the outside and being radiated, that is, reduce electromagnetic radiation and prevent signal interference. As shown in FIG. 2, a heat conduction layer 114 is disposed in a gap between the second chip module 115 and the second shielding case 116, and a gap between the second shielding case 116 and the main board bracket 106, and the heat conduction layer 114 is, for example, the thermal conductive gel or the thermal conductive pad.

For example, an electronic assembly 117 is further disposed on the first surface and/or the second surface of the main board 105, and the electronic assembly 117 includes, for example, a capacitor, an inductor, a resistor, and another electronic component that generates no heat or generates little heat.

As shown by a dotted line arrow in FIG. 2, for the first chip module 109, a heat transfer path thereof is as follows: the first chip module 109 - the heat conduction layer 114 - the first shielding case 113 - the heat conduction layer 114 - the middle frame 103 - the graphite layer 108 - the display screen 102. For the second chip module 115, a heat transfer path thereof is as follows: the second chip module 115 - the heat conduction layer 114 - the second shielding case 116 - the heat conduction layer 114 - the main board bracket 106 -- the graphite layer 108 - the rear cover 104.

In the manner shown in FIG. 2, heat is conducted for the chip in only one direction, and heat dissipation efficiency is relatively low. Consequently, the chip generates heat seriously, thereby suppressing full release of chip performance, easily causing heating or lagging of the mobile phone, and affecting user experience.

Based on the foregoing descriptions, an embodiment of this application provides a new heat dissipation structure, in which heat may be conducted for the chip in two directions, so that heat dissipation efficiency is higher, thereby alleviating heating of the chip, facilitating release of chip performance, and enhancing user experience.

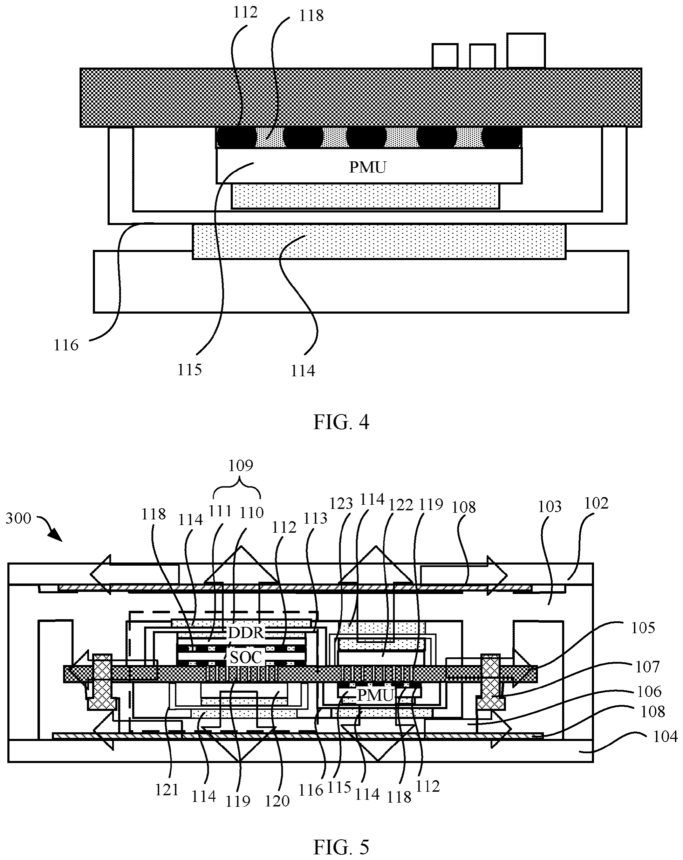

FIG. 3 is a schematic cross-sectional view of an electronic device according to an embodiment of this application. FIG. 4 is a partially enlarged view of a dotted line region in FIG. 3.

Referring to FIG. 3 and FIG. 4, an electronic device 200 provided in this embodiment of this application includes a display screen 102, a middle frame 103, and a rear cover 104, where the middle frame 103 and the rear cover 104 constitute the housing 101 in FIG. 1. The display screen 102 and the rear cover 104 are mounted on the middle frame 103. The display screen 102, the middle frame 103, and the rear cover 104 jointly form an accommodating cavity, and various components required by the device are mounted in the accommodating cavity, such as a processor (SOC), a battery, and a camera module. As shown in FIG. 3, a main board 105 and a main board bracket 106 are mounted on the middle frame 103, and the main board 105 is sandwiched between the middle frame 103 and the main board bracket 106, and the main board bracket 106 is fixed on the middle frame 103 by using a fastener 107 such as a screw. In the example shown in FIG. 3, a graphite layer 108 is coated in a gap between the display screen 102 and the middle frame 103, and a gap between the main board bracket 106 and the rear cover 104. Heat generated by an electronic component on the main board 105 may be dissipated to the outside with the help of the display screen 102 and the rear cover 104 by using the graphite layer 108.

As shown in FIG. 3, the main board 105 includes a first surface and a second surface that are opposite to each other, the first surface is a surface of a side facing the display screen 102, and the second surface is a surface of a side facing the rear cover 104. For example, a first chip module 109 is fixed on the first surface of the main board 105. For example, the first chip module 109 includes a first chip 110 such as the SOC chip and a second chip 111 such as a DDR chip. The first chip 110 is welded on the first surface of the main board 105 by using a solder ball 112. The second chip 111 is welded on the first chip 110 by using a solder ball 112. A first shielding case 113 is further mounted on the first surface of the main board 105, and is configured to shield the first chip module 109, to prevent radiation to the outside and being radiated, that is, reduce electromagnetic radiation and prevent signal interference. As shown in FIG. 3, a heat conduction layer 114 is disposed in a gap between the second chip 111 and the first shielding case 113, and a gap between the first shielding case 113 and the middle frame 105, and the heat conduction layer 114 is, for example, a thermal conductive gel or a thermal conductive pad. As shown in FIG. 3, a thermal conductive underfill (underfill) 118 is formed between the first chip 110 and the main board 105, and between the first chip 110 and the second chip 111, that is, a bottom filling process is used to fill the bottoms of the first chip 110 and the second chip 111, and the solder balls 112 of the first chip 110 and the second chip 111 are surrounded by the thermal conductive underfill 118.

For example, a second chip module 115 is fixed on the second surface of the main board 105. The second chip module 115 includes a third chip, and the third chip is, for example, a PMU chip. The second chip module 115 is welded on the second surface of the main board 105 by using the solder ball 112. A second shielding case 116 is further mounted on the second surface of the main board 105, and is configured to shield the second chip module 115, to prevent radiation to the outside and being radiated, that is, reduce electromagnetic radiation and prevent signal interference. As shown in FIG. 3, a heat conduction layer 114 is disposed in a gap between the second chip module 115 and the second shielding case 116, and a gap between the second shielding case 116 and the main board bracket 106, and the heat conduction layer 114 is, for example, the thermal conductive gel or the thermal conductive pad. As shown in FIG. 3 and FIG. 4, a thermal conductive underfill (underfill) 118 is filled between the second chip module 115 and the main board 105, that is, the bottom filling process is used to fill the bottom of the second chip module 115, and the solder ball 112 of the second chip module 115 is surrounded by the thermal conductive underfill 118.

It should be noted that, in this embodiment of this application, the thermal conductive underfill 118 completely wraps the solder balls 112 of the first chip module 109 and the second chip module 115, and completely fills the bottoms of the first chip module 109 and the second chip module 115.

For example, in this embodiment of this application, the thermal conductive underfill 118 is a bottom filler material with high thermal conductivity, for example, the thermal conductivity of the thermal conductive underfill 118 is greater than or equal to 0.5 w/m·K. In this way, the thermal conductive underfill 118 has relatively high thermal conductivity, and has a relatively good heat conduction capability. Therefore, as shown by a dotted line arrow in FIG. 3, heat generated by the first chip 110 and the second chip 111, on the one hand, may be dissipated to the outside by using a path of the first chip module 109 - the heat conduction layer 114 - the first shielding case 113 - the heat conduction layer 114 - the middle frame 103 - the graphite layer 108 - the display screen 102. On the other hand, the heat may be distributed to the outside by using a path of the first chip module 109 - the thermal conductive underfill 118 - the middle frame 105. In this way, heat may be conducted for the first chip module 109 in two directions, thereby improving heat dissipation efficiency, reducing an amount of heat generated by the first chip module 109, facilitating performance release for the first chip module 109, and enhancing user experience.

On the one hand, heat generated by the second chip module 115 may be dissipated to the outside by using the second chip module 115 - the heat conduction layer 114 - the second shielding case 116 - the heat conduction layer 114 - the main board bracket 106 - the graphite layer 108 - the rear cover 104. On the other hand, the heat may be dissipated to the outside by using a path of the second chip module 1115 - the thermal conductive underfill 118 - the middle frame 105. In this way, heat may be conducted for the second chip module 115 in two directions, thereby improving heat dissipation efficiency, reducing an amount of heat generated by the second chip module 115, facilitating performance release for the second chip module 115, and enhancing user experience.

It can be learned from the foregoing descriptions that, using the heat dissipation structure in this embodiment of this application can facilitate transfer of the heat of the chip to the main board PCB in addition to the screen side or the rear cover side, so that the heat of the chip is transferred in both the forward and backward directions, thereby improving heat dissipation efficiency, reducing system heat, and lowering a temperature, and thus facilitating performance release for the chip and enhancing user experience.

For example, an electronic assembly 117 is further disposed on the first surface and/or the second surface of the main board 105, and the electronic assembly 117 includes, for example, a capacitor, an inductor, a resistor, and another electronic component that generates no heat or generates little heat.

It should be understood that, although the first chip module (for example, the SOC and the DDR) and the second chip module (for example, the PMU) are used in this embodiment of this application to describe a heat dissipation principle of this application, it does not indicate that the heat dissipation structure of this application can be used only for the two groups of chip modules, but may be applied to all chips that generate heat. In addition, this application focuses on heat dissipation for the chip in two directions. A heat dissipation path in each direction is not limited to the manner shown in FIG. 3, and may be modified and improved as required. For example, there may be no middle frame between the chip and the screen (that is, there is no structural member of the middle frame between the chip and the screen), or there is no main board bracket between the chip and the rear cover (that is, there is no structural member of the main board bracket between the chip and the rear cover). In this case, heat dissipation efficiency can be improved as well by using the principle of this application.

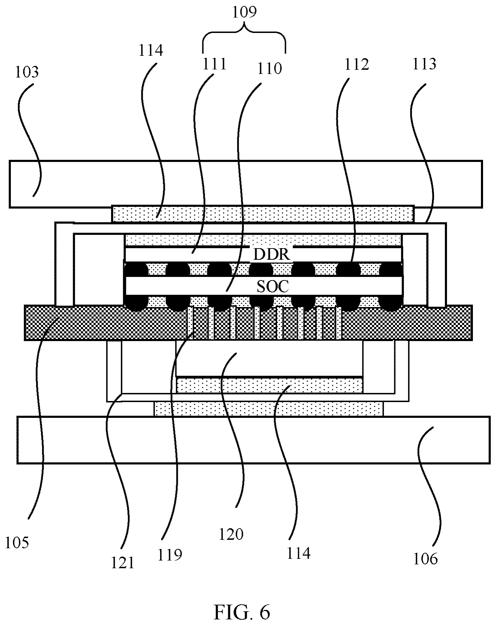

FIG. 5 is a schematic cross-sectional view of an electronic device according to another embodiment of this application. FIG. 6 is a partially enlarged view of a dotted line region in FIG. 5.

Referring to FIG. 5 and FIG. 6, an electronic device 300 provided in this embodiment of this application includes a display screen 102, a middle frame 103, and a rear cover 104, where the middle frame 103 and the rear cover 104 constitute the housing 101 in FIG. 1. The display screen 102 and the rear cover 104 are mounted on the middle frame 103. The display screen 102, the middle frame 103, and the rear cover 104 jointly form an accommodating cavity, and various components required by the device are mounted in the accommodating cavity, such as a processor (SOC), a battery, and a camera module. As shown in FIG. 5, a main board 105 and a main board bracket 106 are mounted on the middle frame 103, and the main board 105 is sandwiched between the middle frame 103 and the main board bracket 106, where the main board bracket 106 is fixed on the middle frame 103 by using a fastener 107 such as a screw. In the example shown in FIG. 5, a graphite layer 108 is coated in a gap between the display screen 102 and the middle frame 103, and a gap between the main board bracket 106 and the rear cover 104. Heat generated by an electronic component on the main board 105 may be dissipated to the outside with the help of the display screen 102 and the rear cover 104 by using the graphite layer 108.

As shown in FIG. 5, the main board 105 includes a first surface and a second surface that are opposite to each other, the first surface is a surface of a side facing the display screen 102, and the second surface is a surface of a side facing the rear cover 104. For example, a first chip module 109 is fixed on the first surface of the main board 105. For example, the first chip module 109 includes a first chip 110 such as an SOC chip and a second chip 111 such as a DDR chip. The first chip 110 is welded on the first surface of the main board 105 by using a solder ball 112. The second chip 111 is welded on the first chip 110 by using a solder ball 112. A first shielding case 113 is further mounted on the first surface of the main board 105, and is configured to shield the first chip module 109, to prevent radiation to the outside and being radiated, that is, reduce electromagnetic radiation and prevent signal interference. As shown in FIG. 3, a heat conduction layer 114 is disposed in a gap between the second chip 111 and the first shielding case 113, and a gap between the first shielding case 113 and the middle frame 105, and the heat conduction layer 114 is, for example, a thermal conductive gel or a thermal conductive pad. As shown in FIG. 5 and FIG. 6, a thermal conductive underfill (underfill) 118 is filled between the first chip 110 and the main board 105, and between the first chip 110 and the second chip 111, that is, a bottom filling process is used to fill the bottoms of the first chip 110 and the second chip 111, and the solder balls 112 of the first chip 110 and the second chip 111 are surrounded by the thermal conductive underfill 118.

As shown in FIG. 5, in this embodiment, a heat dissipation hole 119 is made in an area, on the main board 105, in which the first chip module 109 is located, or a heat dissipation hole 119 is made in an area that is on the main board 105 and that corresponds to a bottom of the first chip module 109, and the heat dissipation hole 119 is filled with the thermal conductive underfill 118, so that heat at the bottom of the first chip module 109 can be transferred to the second surface of the main board 105.

Meanwhile, a first thermal sheet 120 and a third shielding case 121 that shields the first thermal sheet 120 are mounted in an area that is on the second surface of the main board 105 and that corresponds to the first chip module 109. A heat conduction layer 114, such as a thermal conductive gel or a thermal conductive pad, is disposed in a gap between the first thermal sheet 120 and the third shielding case 121, and a gap between the third shielding case 121 and the main board bracket 106. The first thermal sheet 120 is made of a metal material, for example, copper or another metal material with good heat conduction performance. The first thermal sheet 120 is of a planar structure or a sheet-like structure, has no obvious deformation, and is substantially attached to the main board 105. A gap between the first thermal sheet and the main board is completely filled with the thermal conductive underfill 118. In this way, after the heat generated by the first chip module 109 is transferred to the second surface of the main board 105 through the heat dissipation hole 119, the heat may be transferred to the main board bracket 106 through the first thermal sheet 120, the heat conduction layer 114, and the third shielding case 121, and then is transferred to the rear cover 104 through the graphite layer 108, so as to be dissipated to the outside.

For example, a second chip module 115 is fixed on the second surface of the main board 105. The second chip module 115 includes a third chip, and the third chip is, for example, a PMU chip. The second chip module 115 is welded on the second surface of the main board 105 by using the solder ball 112. A second shielding case 116 is further mounted on the second surface of the main board 105, and is configured to shield the second chip module 115 to prevent radiation to the outside and being radiated, that is, reduce electromagnetic radiation and prevent signal interference. As shown in FIG. 3, a heat conduction layer 114 is disposed in a gap between the second chip module 115 and the second shielding case 116, and a gap between the second shielding case 116 and the main board bracket 106, and the heat conduction layer 114 is, for example, the thermal conductive gel or the thermal conductive pad. As shown in FIG. 5, a thermal conductive underfill (underfill) 118 is filled between the second chip module 115 and the main board 105, that is, a bottom filling process is used to fill the bottom of the second chip module 115, and the solder ball 112 of the second chip module 115 is surrounded by the thermal conductive underfill 118.

As shown in FIG. 5, in this embodiment, a heat dissipation hole 119 is made in an area, on the main board 105, in which the second chip module 115 is located, or a heat dissipation hole 119 is made in an area that is on the main board 105 and that corresponds to a bottom of the second chip module 115, and the heat dissipation hole 119 is filled with the thermal conductive underfill 118, so that the heat at the bottom of the second chip module 115 can be transferred to the first surface of the main board 105.

Meanwhile, a second thermal sheet 122 and a fourth shielding case 123 that shields the second thermal sheet 122 are mounted in an area that is on the first surface of the main board 105 and that corresponds to the second chip module 115. A heat conduction layer 114, such as a thermal conductive gel or a thermal conductive pad, is disposed in a gap between the second thermal sheet 122 and the fourth shielding case 123, and a gap between the fourth shielding case 123 and the middle frame 103. The second thermal sheet 122 is made of a metal material, for example, copper or another metal material with good heat conduction performance. The second thermal sheet 122 is of a planar structure or a sheet-like structure, has no obvious deformation, and is which is basically adherent to the main board 105. A gap between the second thermal sheet and the main board is completely filled with the thermal conductive underfill 118. In this way, after the heat generated by the second chip module 115 is transferred to the first surface of the main board 105 through the heat dissipation hole 119, the heat may be transferred to the middle frame 103 through the second thermal sheet 122, the heat conduction layer 114, and the fourth shielding case 123, and then is transferred to the display screen 102 through the graphite layer 108, so as to be dissipated to the outside.

It should be noted that, in this embodiment of this application, the thermal conductive underfill 118 completely wraps the solder balls 112 of the first chip module 109 and the second chip module 115, and completely fills the bottoms of the first chip module 109 and the second chip module 115.

It should be further noted that, in this embodiment of this application, the heat dissipation hole 119 is located in an area, on the main board 105, in which the chip is located, and is spaced apart from a position of the solder ball 112 by a specific distance. For example, a distance between the heat dissipation hole 119 and the solder ball 112 is greater than 30 um.

For example, in this embodiment of this application, a diameter of the heat dissipation hole 119 is 60-90 um, for example, may be 60 um, 70 um, 80 um, or 90 um.

For example, in this embodiment of this application, the thermal conductive underfill 118 is a bottom filler material with high thermal conductivity, for example, the thermal conductivity of the thermal conductive underfill 118 is greater than or equal to 0.5 w/m·K. In this way, the thermal conductive underfill 118 has relatively high thermal conductivity, and has a relatively good heat conduction capability. Therefore, as shown by a dotted line arrow in FIG. 5, heat generated by the first chip 110 and the second chip 111, on the one hand, may be dissipated to the outside by using a path of the first chip module 109 - the heat conduction layer 114 - the first shielding case 113 - the heat conduction layer 114 - the middle frame 103 - the graphite layer 108 - the display screen 102. On the other hand, the heat may be dissipated to the outside by using a path of the first chip module 109 - the heat dissipation hole 119 - the first thermal sheet 120 - the heat conduction layer 114 - the third shielding case 121 - the heat conduction layer 114 - the main board bracket 106 - the graphite layer 108 - the rear cover 104. In addition, the heat may alternatively be dissipated to the outside by using a path of the first chip module 109 - the thermal conductive underfill 118 - the middle frame 105. In other words, in this manner, the heat generated by the first chip module 109 may be dissipated through the display screen and the rear cover from two directions in the Z direction, and may alternatively be dissipated through the middle frame in the X direction and the Y direction. In this way, heat may be conducted for the first chip module 109 in a plurality of directions, thereby improving heat dissipation efficiency, reducing an amount of heat generated by the first chip module 109, facilitating performance release for the first chip module 109, and enhancing user experience.

The heat generated by the second chip module 115, on the one hand, may be dissipated to the outside by using the second chip module 115 - the heat conduction layer 114 - the second shielding case 116 - the heat conduction layer 114 - the main board bracket 106 - the graphite layer 108 - the rear cover 104. On the other hand, the heat is dissipated to the outside by the second chip module 115 - the heat dissipation hole 119 - the second thermal sheet 122 - the heat conduction layer 114 - the fourth shielding case 123 - the heat conduction layer 114 - the middle frame 103 - the graphite layer 108 - the display screen 102. In addition, the heat may alternatively be dissipated to the outside by using a path of the second chip module 1115 - the thermal conductive underfill 118 - the middle frame 105. In other words, in this manner, the heat generated by the second chip module 115 may be dissipated through the display screen and the rear cover from two directions in the Z direction, and may alternatively be dissipated through the middle frame in the X direction and the Y direction. In this way, heat may be conducted for the second chip module 115 in a plurality of directions, thereby improving heat dissipation efficiency, reducing an amount of heat generated by the second chip module 115, facilitating performance release for the second chip module 115, and enhancing user experience.

It can be learned from the foregoing descriptions that, using the heat dissipation structure in this embodiment of this application may completely export the heat of the chip in two directions (two directions in the thickness direction), thereby improving heat dissipation efficiency, reducing system heat, and lowering a temperature, and thus facilitating performance release for the chip and enhancing user experience.

For example, an electronic assembly 117 is further disposed on the first surface and/or the second surface of the main board 105, and the electronic assembly 117 includes, for example, a capacitor, an inductor, a resistor, and another electronic component that generates no heat or generates little heat.

It should be understood that, although the first chip module (for example, the SOC and the DDR) and the second chip module (for example, the PMU) are used in this embodiment of this application to describe a heat dissipation principle of this application, it does not indicate that the heat dissipation structure of this application can be used only for the two groups of chip modules, but may be applied to all chips that generate heat. In addition, this application focuses on heat dissipation for the chip in two directions. A heat dissipation path in each direction is not limited to the manner shown in FIG. 5, and may be modified and improved as required. For example, there may be no middle frame between the chip and the screen (that is, there is no structural member of the middle frame between the chip and the screen), or there is no main board bracket between the chip and the rear cover (that is, there is no structural member of the main board bracket between the chip and the rear cover). In this case, heat dissipation efficiency can be improved as well by using the principle of this application.

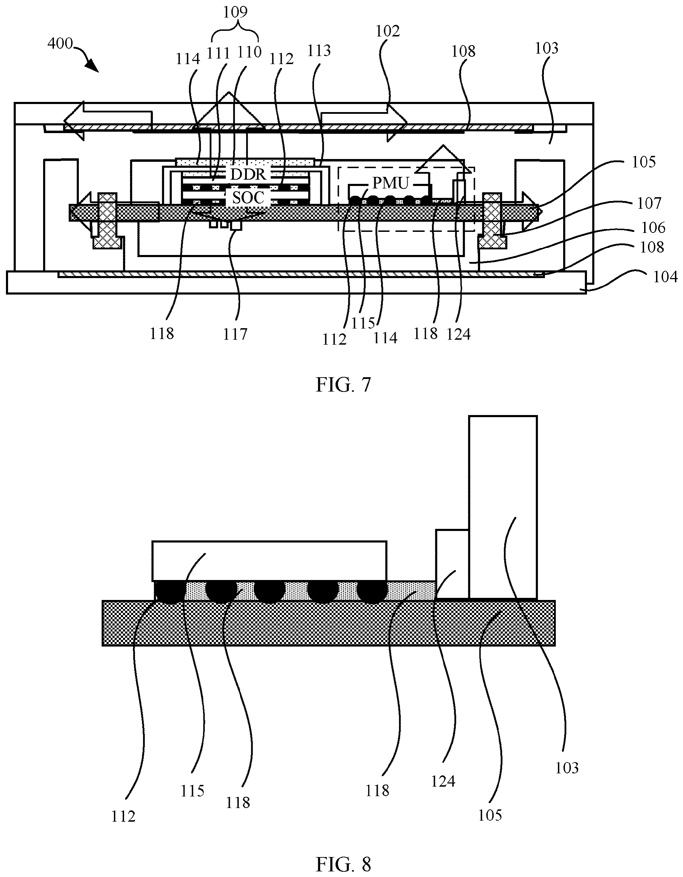

FIG. 7 is a schematic cross-sectional view of an electronic device according to still another embodiment of this application. FIG. 8 is a partially enlarged view of a dotted line region in FIG. 7.

Referring to FIG. 7 and FIG. 8, an electronic device 400 provided in this embodiment of this application includes a display screen 102, a middle frame 103, and a rear cover 104, where the middle frame 103 and the rear cover 104 constitute the housing 101 in FIG. 1. The display screen 102 and the rear cover 104 are mounted on the middle frame 103. The display screen 102, the middle frame 103, and the rear cover 104 jointly form an accommodating cavity, and various components required by the device are mounted in the accommodating cavity, such as a processor (SOC), a battery, and a camera module. As shown in FIG. 7, a main board 105 and a main board bracket 106 are mounted on the middle frame 103, and the main board 105 is sandwiched between the middle frame 103 and the main board bracket 106, where the main board bracket 106 is fixed on the middle frame 103 by using a fastener 107 such as a screw. In the example shown in FIG. 3, a graphite layer 108 is disposed in a gap between the display screen 102 and the middle frame 103, and a gap between the main board bracket 106 and the rear cover 104. Heat generated by an electronic component on the main board 105 may be dissipated to the outside with the help of the display screen 102 and the rear cover 104 by using the graphite layer 108.

As shown in FIG. 7, the main board 105 includes a first surface and a second surface that are opposite to each other, the first surface is a surface of a side facing the display screen 102, and the second surface is a surface of a side facing the rear cover 104. For example, a first chip module 109 is fixed on the first surface of the main board 105. For example, the first chip module 109 includes a first chip 110 such as an SOC chip and a second chip 111 such as a DDR chip. The first chip 110 is welded on the first surface of the main board 105 by using a solder ball 112. The second chip 111 is welded on the first chip 110 by using a solder ball 112. A first shielding case 113 is further mounted on the first surface of the main board 105, and is configured to shield the first chip module 109, to prevent radiation to the outside and being radiated, that is, reduce electromagnetic radiation and prevent signal interference. As shown in FIG. 7, a heat conduction layer 114 is disposed in a gap between the second chip 111 and the first shielding case 113, and a gap between the first shielding case 113 and the middle frame 105, and the heat conduction layer 114 is, for example, a thermal conductive gel or a thermal conductive pad. As shown in FIG. 7, a thermal conductive underfill (underfill) 118 is filled between the first chip 110 and the main board 105, and between the first chip 110 and the second chip 111, that is, a bottom filling process is used to fill the bottoms of the first chip 110 and the second chip 111, and the solder balls 112 of the first chip 110 and the second chip 111 are surrounded by the thermal conductive underfill 118.

For example, a second chip module 115 is fixed on the first surface of the main board 105. The second chip module 115 includes a third chip, and the third chip is, for example, a PMU chip. The second chip module 115 is welded on the first surface of the main board 105 by using the solder ball 112. A shielding case and a heat conduction layer may also be disposed on the first surface of the main board 105, which are not shown herein for a brevity purpose.

In this embodiment of this application, to improve heat dissipation efficiency, a channel is formed between the second chip module 115 and a nearby welded metal member 124, and the channel is filled with the thermal conductive underfill 118. In this way, heat may be conducted to the metal member near the chip, and then the heat is exported to the middle frame 103 through the metal member, thereby implementing two-way export of the heat of the chip, improving heat dissipation efficiency, facilitating performance release for the chip, and enhancing user experience.

For example, copper plating may be performed between the second chip module 115 and the nearby welded metal member 124, and then two sides may be coated with green oil, which is made into a channel form. Then, the channel is filled with the thermal conductive underfill 118. In other words, a heat dissipation channel is made by using the green oil between the second chip module and the middle frame/welded metal member, and the heat dissipation channel is filled with the thermal conductive underfill 118. In this way, the green oil on both sides limits the thermal conductive underfill 118 to prevent the thermal conductive underfill 118 from flowing arbitrarily, thereby ensuring that the thermal conductive underfill 118 between the second chip module 115 and the welded metal member 124 forms a good transfer of heat.

It should be noted that, in this embodiment of this application, the thermal conductive underfill 118 completely wraps the solder balls 112 of the first chip module 109 and the second chip module 115, and completely fills the bottoms of the first chip module 109 and the second chip module 115.

For example, in this embodiment of this application, the thermal conductive underfill 118 is a bottom filler material with high thermal conductivity, for example, the thermal conductivity of the thermal conductive underfill 118 is greater than or equal to 0.5 w/m·K. In this way, the thermal conductive underfill 118 has relatively high thermal conductivity, and has a relatively good heat conduction capability. Therefore, as shown by a dotted line arrow in FIG. 7, heat generated by the first chip 110 and the second chip 111, on the one hand, may be dissipated to the outside by using a path of the first chip module 109 - the heat conduction layer 114 - the first shielding case 113 - the heat conduction layer 114 - the middle frame 103 - the graphite layer 108 - the display screen 102. On the other hand, the heat may be dissipated to the outside by using a path of the first chip module 109 - the thermal conductive underfill 118 - the middle frame 105. In this way, the heat may be conducted for the first chip module 109 in two directions, thereby improving heat dissipation efficiency, reducing an amount of heat generated by the first chip module 109, facilitating performance release for the first chip module 109, and enhancing user experience.

On the one hand, heat generated by the second chip module 115 may be dissipated to the outside through the display screen 102 by using a path similar to that of the first chip module. On the other hand, the heat may be conducted to the middle frame 105 in a manner of the thermal conductive underfill 118 - the welded metal member 124, and then dissipated to the outside through the middle frame 105. This can implement two-way export of the heat of the chip, improve heat dissipation efficiency, facilitate performance release for the chip, and enhance user experience.

It should be understood that, in this embodiment of this application, the heat is conducted to the nearby welded metal member 124 through the thermal conductive underfill 118, and then the heat is transferred to the middle frame 103 through the welded metal member 124. However, in another embodiment, the heat may alternatively be directly conducted to the middle frame 103 through the thermal conductive underfill 118. A specific manner to be used depends on whether the welded metal member or the middle frame is adjacent to the chip, that is, whether the welded metal member exists between the chip and the middle frame.

It should be further understood that, in FIG. 7 and FIG. 8, the thermal conductive underfill 118 is disposed near the second chip module 115 only to conduct the heat to the welded metal member, which, however, is shown merely as an example for describing the principle of this application. Actually, the foregoing structure may also be disposed near the first chip module 109 to conduct the heat to the welded metal member, and further conduct the heat to the middle frame for heat dissipation.

It can be learned from the foregoing descriptions that, using the heat dissipation structure in this embodiment of this application facilitates transfer of the heat of the chip to the main board PCB in addition to the screen side or the rear cover side, so that the heat of the chip is transferred in both the forward and backward directions, thereby improving heat dissipation efficiency, reducing system heat, and lowering a temperature, and thus facilitating performance release for the chip and enhancing user experience.

For example, an electronic assembly 117 is further disposed on the first surface and/or the second surface of the main board 105, and the electronic assembly 117 includes, for example, a capacitor, an inductor, a resistor, and another electronic component that generates no heat or generates little heat.

It should be understood that, although the first chip module (for example, the SOC and the DDR) and the second chip module (for example, the PMU) are used in this embodiment of this application to describe a heat dissipation principle of this application, it does not indicate that the heat dissipation structure of this application can be used only for the two groups of chip modules, but may be applied to all chips that generate heat. In addition, this application focuses on heat dissipation for the chip in two directions. A heat dissipation path in each direction is not limited to the manner shown in FIG. 3, and may be modified and improved as required. For example, there may be no middle frame between the chip and the screen (that is, there is no structural member of the middle frame between the chip and the screen), or there is no main board bracket between the chip and the rear cover (that is, there is no structural member of the main board bracket between the chip and the rear cover). In this case, heat dissipation efficiency can be improved as well by using the principle of this application.

As described above, the foregoing embodiments are merely intended to describe the technical solutions in this application, but not intended to limit this application. Although this application is described in detail with reference to the foregoing embodiments, persons of ordinary skill in the art should understand that they may still make modifications to the technical solutions described in the foregoing embodiments or make equivalent replacements to some technical features thereof. However, these modifications or replacements do not make the essence of the corresponding technical solutions depart from the scope of the technical solutions in the embodiments of this application.

## Claims

1. An electronic device, comprising:
a display screen;
a rear cover;
a middle frame, wherein the middle frame is located between the display screen and the rear cover, and the display screen and the rear cover are mounted on the middle frame;
a main board, wherein the main board is mounted on the middle frame and located between the display screen and the rear cover, and the main board comprises a first surface facing the display screen and a second surface facing the rear cover;
a first chip module, wherein the first chip module is welded on the first surface of the main board by using a solder ball; and
a first shielding case, wherein the first shielding case is located on the first surface of the main board, and shields the first chip module, wherein
a heat conduction layer is formed between the first chip module and the first shielding case, and between the first shielding case and the display screen; and
a thermal conductive underfill that wraps the solder ball is filled between the first chip module and the main board, and thermal conductivity of the thermal conductive underfill is greater than or equal to 0.5 w/m·K.

2. The electronic device according to claim 1, further comprising:
a second chip module, wherein the second chip module is welded on the second surface of the main board by using a solder ball; and
a second shielding case, wherein the second shielding case is located on the second surface of the main board, and shields the second chip module, wherein
a heat conduction layer is formed between the second chip module and the second shielding case, and between the second shielding case and the rear cover; and
the thermal conductive underfill that wraps the solder ball is filled between the second chip module and the main board.

3. The electronic device according to claim 1, further comprising:
a heat dissipation hole, wherein the heat dissipation hole is located in an area, on the main board, in which the first chip module is located, and runs through the main board, and the heat dissipation hole is filled with the thermal conductive underfill;
a first thermal sheet, wherein the first thermal sheet is located at a position that is on the second surface of the main board and that corresponds to the first chip module; and
a third shielding case, wherein the third shielding case is located at a position that is on the second surface of the main board and that corresponds to the first chip module, and shields the first thermal sheet, wherein
a heat conduction layer is formed between the first thermal sheet and the third shielding case, and between the third shielding case and the rear cover.

4. The electronic device according to claim 2, further comprising:
a heat dissipation hole, wherein the heat dissipation hole is located in an area, on the main board, in which the second chip module is located, and runs through the main board, and the heat dissipation hole is filled with the thermal conductive underfill;
a second thermal sheet, wherein the second thermal sheet is located at a position that is on the first surface of the main board and that corresponds to the second chip module; and
a fourth shielding case, wherein the fourth shielding case is located at a position that is on the first surface of the main board and that corresponds to the second chip module, and shields the second thermal sheet, wherein
a heat conduction layer is formed between the second thermal sheet and the fourth shielding case, and between the fourth shielding case and the display screen.

5. The electronic device according to claim 3 or 4, wherein a distance between the heat dissipation hole and the solder ball is greater than or equal to 30 um.

6. The electronic device according to claim 3 or 4, wherein a diameter of the heat dissipation hole is 60-90 um.

7. The electronic device according to claim 2, wherein a heat dissipation channel is formed between the first chip module and/or the second chip module and the middle frame, and the heat dissipation channel is filled with the thermal conductive underfill.

8. The electronic device according to claim 2, wherein a welded metal member is disposed, on the middle frame, adjacent to the first chip module or the second chip module, a heat dissipation channel is formed between the welded metal member and the first chip module or the second chip module, and the heat dissipation channel is filled with the thermal conductive underfill.

9. The electronic device according to claim 1 or 2, wherein the heat conduction layer comprises a thermal conductive gel or a thermal conductive pad.

10. The electronic device according to claim 2, wherein the first chip module comprises at least one chip, the second chip module comprises at least one chip, and the thermal conductive underfill wraps a solder ball of each of the chips.
